# FASCICULE DE BREVET EUROPEEN

(11) **EP 3 319 054 B1**
(45) Date de publication et mention de la délivrance du brevet: **09.12.2020**
(21) Numéro de dépôt: 17195422.5
(22) Date de dépôt: 09.10.2017
(51) Int. Cl.: G08B 5/36, H01H 13/02

(54) **DISPOSITIF DE SIGNALISATION VISUELLE POUR ORGANE DE COMMANDE ET/OU DE VISUALISATION**
VISUELLE ANZEIGEVORRICHTUNG FÜR STEUER- UND/ODER ANZEIGEORGAN
VISUAL SIGNALLING DEVICE FOR CONTROL AND/OR DISPLAY UNIT

(30) Priorité: 08.11.2016 FR 1660766
(43) Date de publication de la demande: 09.05.2018
(73) Titulaire: Schneider Electric Industries SAS, 92500 Rueil-Malmaison (FR)
(72) Inventeur: Thizon, Patrice, 16600 Ruelle sur Touvre (FR)
(74) Mandataire: Mouney, Jérôme

(56) Documents cités:
- EP-A1- 1 821 326
- WO-A1-2005/050686
- DE-A1- 10 225 016
- DE-B3-102015 210 620
- US-A1- 2010 220 495

## Description

### Domaine technique de l'invention

La présente invention se rapporte à un dispositif de signalisation visuelle et à un ensemble de commande et/ou de visualisation comportant ledit dispositif de signalisation visuelle.

### Etat de la technique

Différents organes de commande et/ou de visualisation sont connus dans le domaine industriel. Dans les organes de commande, on distingue par exemple les boutons poussoirs, les boutons tournants, les boutons tournants à clé ou les boutons d'arrêt d'urgence. Ces différents organes sont destinés à générer une commande dans une installation électrique. Il existe également des voyants lumineux dont la fonction est simplement de s'allumer pour signaler un état de fonctionnement particulier à l'opérateur. Certains organes de commande de type bouton-poussoir ou tournant intègrent également une fonction de visualisation.

Ces organes de commande et/ou de visualisation sont fixés à travers une paroi, telle que par exemple la porte d'une armoire électrique. Pour fixer un tel organe de commande, une ouverture d'un diamètre standard est réalisée à travers la paroi. L'organe présente un corps en matériau plastique ou métallique venant s'enfoncer axialement dans ladite ouverture jusqu'à venir en butée. Il présente ainsi une partie avant visible d'un côté de la paroi et une partie arrière invisible, située de l'autre côté de la paroi. Des moyens de fixation coopérant avec sa partie arrière permettent d'assurer sa fixation à travers l'ouverture.

Différentes solutions de signalisation ont déjà été proposées dans l'état de la technique pour signaler visuellement un état particulier d'un organe de commande et/ou de visualisation.

L'élément de signalisation peut être logé dans le corps du dispositif. Il peut également présenter, comme décrit dans la demande de brevet EP0517932A1**,** une configuration annulaire s'étendant autour du corps principal du bouton-poussoir. Des diodes électroluminescentes de l'élément de signalisation sont alors réparties sur une plaque positionnée autour du corps du bouton. Dans cette dernière solution, on s'est aperçus que ces différentes configurations de signalisation peuvent nuire à l'efficacité du bouton d'arrêt d'urgence car la fonction de signalisation ne se trouve pas suffisamment dissociée de la fonction de commande.

Par ailleurs, les solutions de signalisation visuelle intégrées dans le corps des organes de commande et/ou de visualisation sont souvent encombrantes car elles occupent l'axe centrale. De plus, en cas de dysfonctionnement, c'est l'organe complet qui doit être démonté et remplacé. Enfin, les organes de commande classiques, les organes de commande dotées d'une fonction de visualisation et les organes de visualisation doivent être des références commerciales distinctes qu'il est nécessaire de gérer séparément.

Pour remédier à certains de ces inconvénients, il a déjà été proposé de réaliser la fonction de visualisation à l'aide d'un accessoire venant s'adapter sur un organe de commande qui n'en a pas. Ce type d'accessoire se présente sous la forme d'une couronne lumineuse venant se positionner du côté de la partie avant de l'organe entre sa tête de commande et la paroi. Un bloc d'alimentation est pour sa part positionné derrière la paroi pour alimenter des diodes électroluminescentes de la couronne lumineuse. La demande de brevet EP2299462A1 décrit une telle solution.

Cependant, cette solution s'avère peu pratique. Elle est encombrante et nécessite de faire passer un fil entre l'avant et l'arrière de la paroi, ce qui est peu adapté à des contraintes d'utilisation en milieu industriel.

La demande de brevet US2010/220495 décrit également une architecture de bouton poussoir présentant une solution de signalisation lumineuse.

Il existe toujours un besoin de disposer d'une solution de signalisation visuelle qui soit peu encombrante, facile à ajouter à un organe de commande et/ou de visualisation existant et qui permette éventuellement d'attribuer d'autres fonctions à l'organe de commande et/ou de visualisation.

### Exposé de l'invention

L'invention est définie par les revendications annexées. Elle concerne ainsi un dispositif de signalisation visuelle pour organe de commande et/ou de visualisation doté d'un corps et destiné à être monté à travers une ouverture réalisée dans une paroi, ledit dispositif comportant :
- Un élément support comprenant une plateforme présentant une ouverture destinée à être traversée par le corps dudit organe de commande et/ou de visualisation et une première face destinée à être en vis-à-vis d'une face de la paroi,
- Un ensemble de signalisation visuelle fixé sur la première face de ladite plateforme et comprenant au moins une diode électroluminescente destinée à produire un signal lumineux,
- Un bloc de connexion électrique destiné à alimenter ledit ensemble de signalisation visuelle,
- Ladite plateforme comportant au moins un passage radial à travers lequel ladite au moins une diode électroluminescente émet ledit signal lumineux.

Selon un mode de réalisation particulier, l'ensemble de signalisation visuelle comporte une carte électronique sur laquelle est soudée ladite au moins une diode électroluminescente.

Selon une première variante de réalisation, ladite au moins une diode électroluminescente est orientée de manière à émettre son signal lumineux dans une direction principale située dans un plan transversal par rapport à l'axe de l'ouverture.

Selon une particularité, ladite ouverture du dispositif présente un contour circulaire.

Selon une autre particularité, la plateforme comporte des moyens de fixation agencés pour coopérer avec des moyens de fixation correspondants du bloc de connexion électrique.

Selon une autre particularité, le dispositif comporte une bague de serrage solidaire de ladite plateforme.

Un autre but de l"invention consiste à proposer un ensemble de commande et/ou de visualisation, qui permette d'assurer un éclairage satisfaisant, dans un encombrement minimal en hauteur, et qui puisse proposer certaines fonctionnalités supplémentaires. Cet autre but est atteint par un ensemble de commande et/ou de visualisation qui comporte :
- Un organe de commande et/ou de visualisation comprenant un corps défini suivant un axe, une tête de commande et/ou de visualisation monté sur ledit corps, l'organe de commande et/ou de visualisation comportant une collerette agencée pour prendre appui contre une première face d'une paroi, dite face externe, définissant un plan d'appui,
- Ledit ensemble comportant :
- Un dispositif de signalisation visuelle conforme à celui défini ci-dessus, dont l'élément support coopère avec ledit corps de l'organe de commande et/ou de visualisation,
- Un élément en matériau translucide ou transparent agencé pour recevoir ledit signal lumineux émis par l'ensemble de signalisation visuelle dudit dispositif de signalisation visuelle et pour propager ledit signal lumineux,
- Ledit élément en matériau translucide ou transparent comportant une première zone agencée en vis-à-vis du passage radial à travers lequel ladite au moins une diode électroluminescente émet ledit signal lumineux, pour recevoir ledit signal lumineux au-dessous dudit plan d'appui et une deuxième zone prolongeant la première zone jusqu'au plan d'appui ou au-dessus du plan d'appui.

Selon un mode de réalisation particulier, l'élément en matériau translucide ou transparent est formé d'une pièce surmoulée sur le corps dudit organe de commande et/ou de visualisation.

Selon un autre mode de réalisation particulier, l'élément en matériau translucide ou transparent est formé au moins en partie du corps dudit organe de commande et/ou de visualisation.

Selon une autre particularité, l'ensemble comporte une bague de serrage agencée pour maintenir le dispositif de signalisation visuelle en appui contre une deuxième face de la paroi, dite face interne, opposée à ladite face externe.

### Brève description des figures

D'autres caractéristiques et avantages vont apparaître dans la description détaillée qui suit faite en regard des dessins annexés dans lesquels :
- Les figures 1A et 1B illustrent de manière schématique le principe de fonctionnement du dispositif de signalisation visuelle de l'invention.
- Les figures 1C et 1D illustrent des dispositifs de signalisation visuelle selon plusieurs configurations distinctes.
- Les figures 2A à 2C représentent un premier mode de réalisation du dispositif de signalisation visuelle de l'invention.
- Les figures 3A à 3C représentent un deuxième mode de réalisation du dispositif de signalisation visuelle de l'invention.
- Les figures 4A à 4C représentent le dispositif de l'invention associé à un organe de commande de type bouton d'arrêt d'urgence.
- Les figures 5A à 5C représentent le dispositif de l'invention associé à un organe de commande de type bouton tournant.
- Les figures 6A à 6C représentent le dispositif de l'invention associé à un organe de visualisation.

### Description détaillée d'au moins un mode de réalisation

Dans la suite de la description, les termes "haut", "bas", "supérieur", inférieur", "au-dessus", "au-dessous" sont à comprendre en prenant comme référence l'axe (X), visible sur les figures annexées et représenté suivant une direction verticale.

On définit également la partie avant de la paroi qui correspond à la partie visible pour un utilisateur et la partie arrière de la paroi qui correspond à la partie invisible de l'utilisateur.

L'invention est liée au domaine des organes de commande et/ou de visualisation de type industriel, réunis dans un domaine appelé classiquement "boutonnerie". Par organe de commande, on entend de manière non exhaustive un bouton-poussoir, un bouton tournant, un bouton tournant à clé, un bouton d'arrêt d'urgence,... Par organe de visualisation, on entend par exemple un voyant lumineux présentant un capuchon de couleur translucide ou transparent susceptible de laisser passer un signal lumineux vers l'extérieur. Par ailleurs, il est connu qu'un organe de commande tel que défini ci-dessus peut également être doté d'une fonction de visualisation.

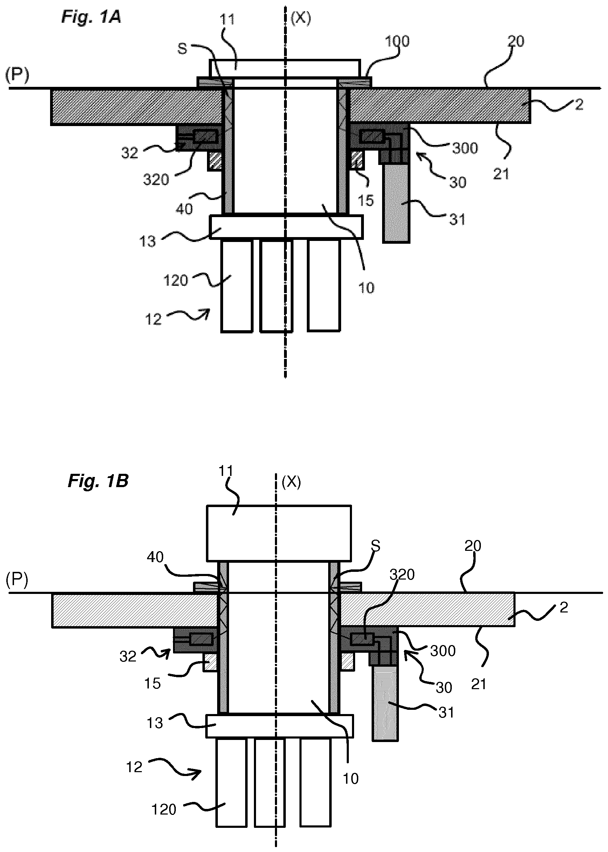

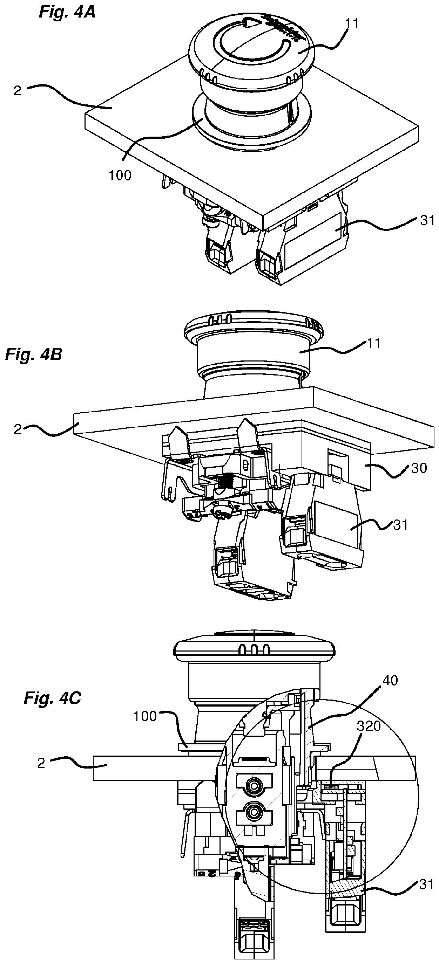

Les figures 1A et 1B permettent d'illustrer le principe de l'invention. Tous les détails de réalisation, notamment de l'organe de commande, ne sont pas forcément visibles sur ces figures. Les figures 4 à 6 sont plus détaillées et représentent des modes de réalisation plus concrets de l'invention.

Un organe de commande et/ou de visualisation est monté en s'engageant dans une ouverture formée à travers une paroi 2 métallique, telle que par exemple la porte d'une armoire électrique ou un pupitre de commande. Pour un bouton-poussoir ou tournant, l'ouverture est par exemple de diamètre normalisé égal à 22 mm ou 25,5mm. La paroi comporte une première face 20, dite externe, et une deuxième face 21, dite interne.

De manière classique un organe de commande et/ou de visualisation comporte un corps 10 se présentant sous la forme d'une pièce tubulaire autour d'un axe (confondu avec l'axe (X) sur les figures) et destiné à être inséré suivant son axe à travers ladite ouverture de la paroi 2. Suivant son axe, le corps 10 comporte une partie inférieure et une partie supérieure qui peuvent être séparées entre elles par un épaulement. La partie supérieure est dotée d'une collerette 100 annulaire destinée à prendre appui sur une première face, dite face externe, de la paroi 2 autour de l'ouverture, de sorte que sa position délimite, suivant un plan d'appui P contre la face externe 20 de la paroi, la partie visible de l'organe située d'un premier côté de la paroi (à l'avant de la paroi) par rapport à la partie invisible de l'organe située d'un deuxième côté de la paroi 2 (à l'arrière de la paroi). Un joint d'étanchéité est par exemple positionné entre la collerette 100 et la surface de la paroi 2.

Un organe de commande et/ou de visualisation comporte des moyens de fixation sur ladite paroi 2. Ces moyens de fixation ne font pas l'objet de la présente demande et ils peuvent être de différentes natures. Les moyens de fixation employés sont par exemple constitués d'un écrou 15 vissé sur un filetage externe réalisé sur la partie inférieure du corps tubulaire du dispositif ou, comme décrits dans le brevet EP0889564B1**,** constitués par une embase qui s'assemble au corps tubulaire, cette embase portant des moyens d'accrochage tels que des vis pointeau ou des bras d'accrochage pivotants manœuvrés au moyen d'une vis. Sur les figures annexées, différents moyens de fixation sont représentés.

Plus particulièrement, un organe de commande tel que par exemple un bouton-poussoir, un bouton d'arrêt d'urgence, un bouton tournant, comporte une tête de commande 11 montée sur le corps et comprenant un bouton actionnable.

Un organe de commande comporte également une unité de contacts électriques. L'unité de contacts 12 comporte un ou plusieurs blocs de contact électrique 120. Chaque bloc de contact électrique comporte un interrupteur à contact mobile actionnable par une pression sur le bouton de l'organe de commande. Un bouton d'arrêt d'urgence comporte ainsi au moins un bloc de contact électrique dont l'interrupteur est configuré en mode normalement fermé (NC pour "normally closed" en anglais).

Pour porter l'unité de contacts, un organe de commande comporte en général une embase 13 de fixation par exemple de forme rectangulaire. Cette embase 13 comporte une ouverture centrale destinée à être traversée par la partie inférieure du corps 10 tubulaire et des moyens de fixation servant à porter de manière amovible les blocs de contacts électriques 120. Selon les configurations, cette embase 13 peut être solidaire des moyens de fixation ou indépendantes de ces moyens de fixation. Dans ce dernier cas, la partie inférieure de l'organe de commande vient s'encliqueter dans ladite embase. Dans un organe de commande, l'action sur le bouton de la tête de commande 11 vient actionner les interrupteurs des blocs de contact de l'unité de contact. Le bouton de la tête de commande peut être réalisé dans un matériau translucide ou transparent permettant de faire passer la lumière, conférant une fonction de signalisation visuelle à l'organe de commande.

Un organe de visualisation de type voyant lumineux comporte pour sa part une tête dotée d'un capuchon translucide 14 ou transparent, permettant de faire passer la lumière. Le capuchon peut être coloré.

L'invention consiste à proposer un nouveau principe de signalisation visuelle pour des organes de commande et/ou de visualisation tels que décrits ci-dessus. La solution de l'invention permet éventuellement de ne plus occuper la partie centrale de l'organe dans laquelle une diode électroluminescente est généralement intégrée pour assurer un éclairage de l'organe et de proposer d'autres fonctionnalités qui seront détaillées ci-dessous.

Ainsi, le dispositif de signalisation visuelle de l'invention se compose d'au moins trois parties principales :
- Un élément support 30,
- Un bloc de connexion électrique 31,
- Un ensemble de signalisation visuelle 32 destiné à générer au moins un signal lumineux et fixé sur ledit élément support 30.

Le bloc de connexion électrique 31 et l'ensemble de signalisation visuelle 32 sont connectés électriquement à travers des contacts et liaisons électriques.

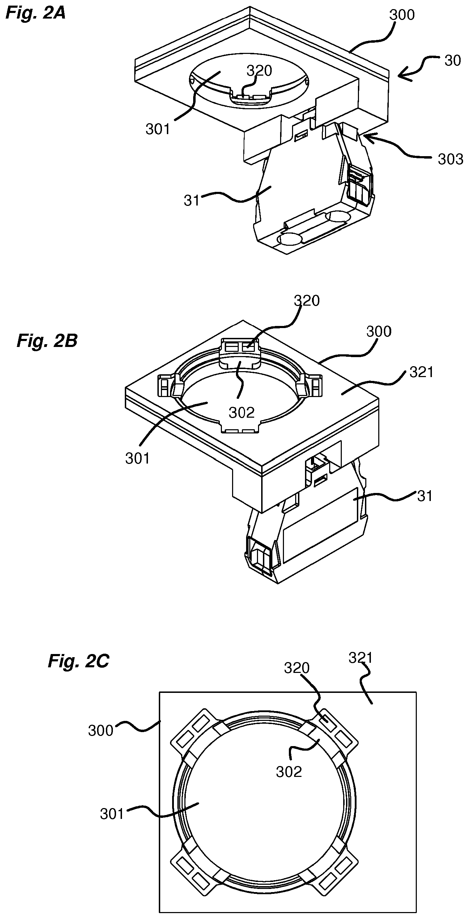

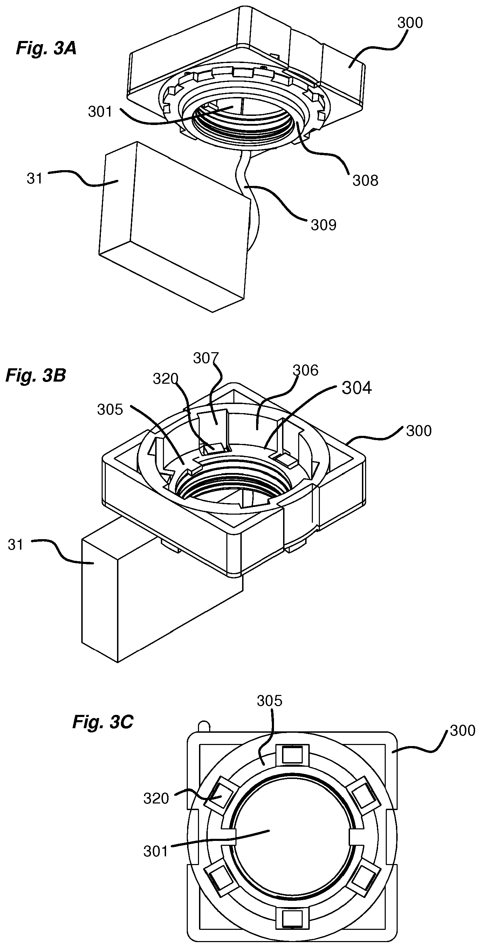

Sur les figures 2A à 2C, le dispositif de signalisation visuelle est représenté selon un premier mode de réalisation et, sur les figures 3A à 3C, le dispositif de signalisation visuelle est représenté selon un deuxième mode distinct.

Dans les deux modes, l'élément support 30 comporte une plateforme 300 par exemple de forme externe rectangulaire et présentant deux faces de support parallèles entre elles et à un plan P et séparées entre elles par l'épaisseur de la plateforme, formant ainsi un boîtier. La plateforme est dotée d'une ouverture 301 de forme tubulaire réalisée suivant un axe perpendiculaire audit plan P, à travers l'épaisseur de la plateforme. Ladite ouverture 301 est de forme générale circulaire et réalisée préférentiellement au centre de la plateforme. L'ouverture présente ainsi une paroi interne cylindrique.

Le bloc de connexion électrique 31 se présente avantageusement sous la même forme qu'un bloc de contact classique d'une unité de contacts telle que décrite ci-dessus. Il comporte notamment un boîtier et des moyens de fixation identiques à ceux des blocs de contact classiques.

Le bloc de connexion électrique comporte avantageusement des moyens de gestion de l'ensemble de signalisation visuelle. Ces moyens de gestion sont par exemple réunis dans une carte électronique logée dans le boîtier du bloc de connexion électrique. Il comporte des bornes de connexion électrique à une source d'alimentation électrique. Dans ce cas, la liaison électrique est réalisée par des fils s'étendant des bornes du bloc de connexion électrique vers la source d'alimentation. En variante de réalisation, le bloc de connexion électrique peut embarquer une source d'alimentation électrique de l'ensemble de signalisation visuelle. Il s'agira par exemple d'une pile électrique. Le bloc de connexion électrique comporte avantageusement des composants de protection aux environnements industriels et perturbés.

L'ensemble de signalisation visuelle 32 comporte pour sa part une ou plusieurs diodes électroluminescentes 320. Les diodes sont rendues solidaires de la plateforme 300 et alimentées par le bloc de connexion électrique 31 décrit ci-dessus. La plateforme 300 comporte avantageusement plusieurs emplacements distincts agencés pour accueillir chacun au moins une diode électroluminescente 320. Ces emplacements sont répartis sur le pourtour de l'ouverture 301 de la plateforme.

Les diodes électroluminescentes 320 sont toutes situées à l'arrière de la paroi 2.

Selon les applications envisagées, la commande de l'ensemble de signalisation visuelle du dispositif peut être réalisée selon différentes variantes :
- Les diodes électroluminescentes 320 peuvent être commandées toutes en même temps. Celles-ci sont alors connectées sur un même circuit de commande, par exemple en parallèle sur ledit circuit. L'ensemble de signalisation visuelle 32 comporte ainsi deux bornes de contact électrique venant se connecter électriquement à deux bornes correspondantes du bloc de connexion électrique.
- Les diodes électroluminescentes 320 sont commandées de manière indépendante ou par groupe (un groupe de diodes comportant au moins diodes et moins de diodes que le nombre total de diodes). Il s'agit alors d'une commande dite en "point à point" dans laquelle chaque groupe de diodes peut être adressé individuellement. Dans ce cas, l'ensemble de signalisation visuelle comporte une borne électrique distincte pour chaque groupe de diodes et une borne commune. Le bloc de connexion électrique comporte la même configuration.

L'état de chaque diode électroluminescente 320 du dispositif, c'est-à-dire son état allumé ou éteint, peut être commandé selon l'une des variantes de réalisation ci-dessous :
- Son état est par exemple commandé par un interrupteur présent dans le bloc de connexion électrique 31. Cet interrupteur peut être lié mécaniquement à au moins un interrupteur à contact mobile d'un bloc de contact de l'unité de contacts.
- Son état est par exemple commandé directement par un automate programmable qui comporte un module de sortie apte à générer une commande d'activation ou de désactivation de la diode électroluminescente. Si les diodes électroluminescentes sont commandées de manière indépendante, une commande distincte devra être générée pour chaque diode électroluminescente. Dans ce cas, la commande agira sur un transistor de commande du circuit d'alimentation de la diode.

Selon le premier mode de réalisation représenté sur les figures 2A à 2C, sur sa première face de support, dite face supérieure, la plateforme 300 est dotée d'un logement destiné à accueillir l'ensemble de signalisation visuelle 32.

Le logement dans la plateforme est préférentiellement formé sur toute la périphérie de l'ouverture 301.

Le logement de la plateforme définit en outre, le long du bord de l'ouverture, lesdits emplacements distincts.

L'ensemble de signalisation visuelle 32 est agencé dans ledit logement de la plateforme. Il comporte avantageusement plusieurs diodes électroluminescentes 320, destinées à venir se positionner chacune dans un emplacement distinct du logement.

Les diodes électroluminescentes peuvent être connectées sur un circuit d'alimentation relié au bloc de connexion électrique. Une connectique particulière peut être prévue pour leur connexion.

Par ailleurs, de manière avantageuse, l'ensemble de signalisation visuelle 32 peut comporter une carte électronique 321 de forme adaptée pour se positionner dans le logement de la plateforme en épousant le contour externe de la face supérieure de la plateforme et en étant découpée dans sa partie centrale pour épouser le contour de l'ouverture 301. Dans l'ensemble de signalisation visuelle, les diodes électroluminescentes 320 sont alors soudées sur la carte électronique 321, de manière à se positionner chacune dans un emplacement distinct du logement. La carte électronique 321 présente idéalement des contacts électriques sur lesquels viennent se connecter des contacts électriques correspondants du bloc de connexion.

A chacun des emplacements, la plateforme 300 comporte un passage radial 302 formé à travers le boîtier de la plateforme. Les passages radiaux sont ainsi répartis sur le pourtour de l'ouverture 301. Au moins une diode électroluminescente 320 distincte est présentée en vis-à-vis de l'un des passages radiaux, de manière à pouvoir générer un signal lumineux à travers ledit passage. Chaque diode 320 génère ainsi un signal lumineux S guidé par un passage radial suivant une direction principale orientée vers le centre de l'ouverture, perpendiculaire à l'axe de l'ouverture et parallèle audit plan P.

Selon le premier mode de réalisation, la plateforme 300 comporte des moyens de fixation mécaniques 303 agencés sur sa deuxième face de support et destinés à coopérer avec des moyens de fixation correspondants du bloc de connexion électrique 31 pour fixer le bloc de connexion électrique. Avantageusement, lors de la fixation du bloc de connexion électrique 31, une connexion électrique est également réalisée. La fixation du bloc de connexion électrique 31 est par exemple réalisée sur la deuxième face de support, le long d'un des bords externes de la plateforme 300.

La fixation de la plateforme par rapport à l'organe de commande pourra être réalisée selon différentes variantes de réalisation. Une solution avantageuse consiste à assurer le positionnement de la plateforme entre les moyens de fixation de l'organe de commande et/ou de visualisation et la face interne 21 de la paroi 2. Ces moyens de fixation pourront être une bague de serrage 15 (correspondant à l'écrou décrit ci-dessus) de l'organe et la face interne de la paroi. Cette bague de serrage 15 est par exemple vissée sur un filetage externe présent sur le corps de l'organe.

Selon la deuxième variante du dispositif représenté sur les figures 3A à 3C, sur sa première face de support, dite face supérieure, pour définir chaque emplacement décrit ci-dessus, la plateforme 300 comporte une cavité 304 ménagée autour de son ouverture 301. Cette cavité 304 définit une première surface 305 transversale en périphérie de l'ouverture 301 et une deuxième surface 306 annulaire cylindrique. La première surface 305 présente plusieurs logements répartis à intervalles réguliers et destinés chacun à accueillir au moins une diode électroluminescente 320 distincte de l'ensemble de signalisation visuelle. Chaque logement se prolonge par un passage 307 formé sur la deuxième surface 306 et orienté dans la direction axiale. Chaque diode 320 logée à un emplacement distinct génère ainsi un signal lumineux guidé suivant une direction principale axiale, c'est-à-dire parallèle à l'axe de l'ouverture.

Selon ce deuxième mode l'élément support comporte une bague de serrage 308 intégrée agencée dans le prolongement de l'ouverture 301 réalisée à travers la plateforme. Cette bague 308 propose un filetage interne permettant de visser l'élément support sur le corps de l'organe de commande et/ou de visualisation. Cette bague est fixée sur la deuxième face de support, dite face inférieure, de la plateforme. L'ensemble formé de la plateforme et de la bague de serrage 308 forme ainsi une seule pièce, par exemple obtenue par moulage dans un matériau plastique.

Selon ce deuxième mode le bloc de connexion électrique 31 n'est pas fixé directement sur la plateforme. Il est relié par un câble 309 à une connectique de l'ensemble de signalisation visuelle.

Le dispositif de signalisation visuelle décrit ci-dessus, selon le premier mode ou le deuxième mode est destiné à coopérer avec l'organe de commande et/ou de visualisation en vue de lui apporter des moyens de signalisation visuelle et à former un ensemble de commande et/ou de visualisation complet.

Selon l'invention, le dispositif de signalisation visuelle est positionné du deuxième côté de la paroi et se situe donc dans la partie invisible de l'extérieur.

Selon un aspect de l'invention, l'ensemble de commande et/ou de visualisation comporte également au moins un élément 40 en matériau translucide ou transparent à travers lequel au moins un signal lumineux généré par le dispositif de signalisation visuelle est émis. Chaque élément 40 en matériau translucide ou transparent comporte au moins une première zone située au-dessous du plan d'appui de l'organe et une deuxième zone, prolongeant de manière continue ladite première zone et située au niveau du plan d'appui ou au-dessus dudit plan d'appui. Ainsi chaque élément 40 en matériau translucide ou transparent est destiné à propager un signal lumineux S reçu par sa première zone vers sa deuxième zone. Selon la configuration adoptée pour l'émission du signal lumineux S, la première zone de chaque élément 40 en matériau translucide ou transparent pourra se prolonger plus ou moins vers l'arrière.

Dans le cas où le dispositif de signalisation comporte au moins une diode électroluminescente 320 agencée de manière à émettre un signal lumineux S à travers un passage radial 302, c'est-à-dire avec une direction principale orientée vers le centre de l'ouverture, perpendiculaire à l'axe de l'ouverture et parallèle audit plan P, ladite première zone de l'élément transparent ou translucide se prolonge vers l'arrière (ou vers la partie inférieure de l'ensemble) de manière à au moins traverser le plan incluant ladite direction principale pour capter ledit signal lumineux et pouvoir le propager vers la partie supérieure de l'ensemble. Il en sera de même pour chaque diode électroluminescente du dispositif. Le signal lumineux est émis exclusivement à travers chaque passage radial formé dans la plateforme et est guidé par celui-ci dans cette direction radiale. Il ne s'agit pas de guider également le signal par un autre passage (par exemple axial) formé dans la plateforme.

Autrement dit, l'élément 40 en matériau transparent ou translucide permet de propager un signal émis à l'arrière de la paroi vers l'avant de la paroi. Dans sa première zone, l'élément en matériau transparent ou translucide s'étend sur une zone strictement supérieure à l'épaisseur de la paroi 2.

Chaque élément 40 en matériau translucide est destiné à recevoir les signaux lumineux émis par chaque diode électroluminescente 320 du dispositif de signalisation visuelle en vue de les propager du dessous de la paroi 2, vers le dessus de la paroi 2.

L'ensemble peut comporter un seul élément 40 en matériau translucide ou transparent formé d'une seule pièce monobloc.

L'élément 40 en matériau translucide peut prendre différentes configurations et présenter différentes particularités. Ces configurations ou particularités seront notamment liées au type de matériau employé pour réaliser le corps de l'organe de commande et/ou de visualisation, celui-ci pouvant être en matériau plastique et/ou métallique.
- Il peut s'agir d'une pièce surmoulée sur le corps de l'organe de commande et/ou de visualisation, sur au moins une partie de la hauteur de celui-ci, incluant la collerette dudit corps. Cette solution pourra être envisagée si le corps est métallique.
- Il peut s'agir de dépôts localisés venant combler des cavités, canaux ou logements réalisés sur le corps de l'organe. Cette solution pourra être envisagée si le corps est métallique. Les dépôts seront par exemple réalisés en matériau plastique translucide ou transparent. Ils pourront être de couleurs différentes.
- Il peut s'agir d'une pièce, par exemple en matériau souple, telle que de la silicone ou du caoutchouc, dans laquelle le corps 10 de l'organe est enfoncé, venant épouser la forme externe dudit corps et sa collerette 100.
- Il peut s'agir du corps 10 de l'organe de commande et/ou de visualisation ce qui permet alors de propager la lumière vers l'axe central de l'organe. Cette solution sera privilégiée dans le cas où le corps est en matériau plastique. Cette solution sera particulièrement avantageuse pour un organe de visualisation, c'est-à-dire un voyant, doté d'un capuchon translucide à son sommet par lequel est diffusé la lumière.
- Il peut s'agir d'une combinaison de différentes solutions évoquées ci-dessus.

L'ensemble peut comporter plusieurs éléments 40 en matériau translucide ou transparent agencés de manière adaptée pour remplir chacun la fonction de propagation d'un signal lumineux distinct. Les différents éléments sont par exemple répartis autour du corps de l'organe de commande et/ou de visualisation. Cette architecture présente un avantage lorsque les diodes sont commandées de manière indépendante, permettant ainsi de fournir un éclairage localisé. Chaque élément en matériau translucide ou transparent permettra par exemple d'indiquer une position distincte d'un bouton tournant. Les éléments pourront avoir des couleurs distinctes, permettant de signaler des états de fonctionnement différents de l'organe.

Selon la configuration de l'élément 40, il est à noter que l'ouverture à travers la paroi 2 peut être réalisée avec un diamètre supérieur à celui normalement employé pour un organe non muni de l'élément en matériau translucide. La présence de l'élément en matériau translucide peut ainsi accentuer le diamètre externe maximal de l'organe au niveau de l'ouverture de la paroi.

Chaque signal lumineux S émis par le dispositif se propage, par réflexions successives, à travers l'élément en matériau translucide ou transparent, de sa première zone située en vis-à-vis d'une diode électroluminescente vers sa deuxième zone, de manière à déboucher au-dessus du plan d'appui et ainsi diffuser la lumière émise vers l'extérieur. La propagation sera d'autant plus facilitée lorsque l'élément 40 est positionné sur une surface opaque.

L'ensemble de l'invention est ainsi mis en oeuvre de la manière suivante :
- L'organe de commande et/ou de visualisation est inséré à travers l'ouverture formée dans la paroi 2, de sorte que sa collerette 100 vienne en appui contre la face externe 20 de la paroi 2, la partie inférieure du corps de l'organe étant située au-dessous dudit plan d'appui et masquée par ladite paroi.
- La plateforme 300 du dispositif de signalisation visuelle est enfilée autour du corps 1 de l'organe, par vissage ou par simple translation, par exemple jusqu'à venir en butée contre la face interne 21 de la paroi. Dans le cas où la plateforme est vissée, celle-ci assure aussi la fixation de l'organe. Dans le cas de la translation, celle-ci est par exemple maintenue en appui contre la face interne 21 de la paroi par la bague de serrage 15 classique, habituellement employée pour la fixation de l'organe.
- Le bloc de connexion électrique 31 est connecté sur l'ensemble de signalisation visuelle 32 du dispositif. Selon la configuration, le bloc de connexion électrique 31 est fixé sur la plateforme 300 ou sur l'embase 13. Dans le premier cas, la connexion électrique est directe, sans câble de liaison, entre les bornes électriques du bloc de connexion et les bornes électriques l'ensemble de signalisation visuelle. Dans le deuxième cas, un câble de liaison 309 électrique assure la connexion électrique entre les bornes électriques du bloc de connexion électrique 31 et celles de l'ensemble de signalisation visuelle 32.

Les figures 1A à 1D illustrent différentes variantes de fonctionnement du dispositif de signalisation visuelle, agencé sur un organe de commande et/ou de visualisation.

Sur la figure 1A, le dispositif de l'invention coopère avec un organe de commande, tel que par exemple un bouton poussoir. Le dispositif est par exemple réalisé selon le premier mode de réalisation décrit ci-dessus en liaison avec les figures 2A à 2C. Les diodes 320 sont ainsi agencées pour générer des signaux lumineux suivant une direction principalement radiale. L'élément 40 en matériau translucide ou transparent est formé au moins en partie du corps 10 de l'organe de commande en intégrant sa collerette 100. Le signal lumineux S généré par chaque diode électroluminescente 320 est émis principalement suivant la direction radiale vers la première zone de l'élément en matériau translucide située en vis-à-vis et se propage dans celui-ci vers sa deuxième zone située au niveau de la partie supérieure de l'organe de commande. Celui-ci est véhiculé jusqu'à la collerette 100, permettant d'illuminer celle-ci.

Sur la figure 1B, le dispositif de l'invention coopère avec un organe de commande de type bouton d'arrêt d'urgence. Dans cette réalisation, l'élément 40 est formé au moins en partie du corps 10 de l'organe et s'étend par une première zone en vis-à-vis de chaque diode électroluminescente 320 qui fournit un éclairage suivant une direction principale radiale et se prolonge par sa deuxième zone au-dessus de la collerette 100. Le signal lumineux S généré par chaque diode électroluminescente 320 est alors diffusé à la fois dans la collerette 100 et au-dessus de celle-ci, rendant visible l'organe en vue de face et de côté.

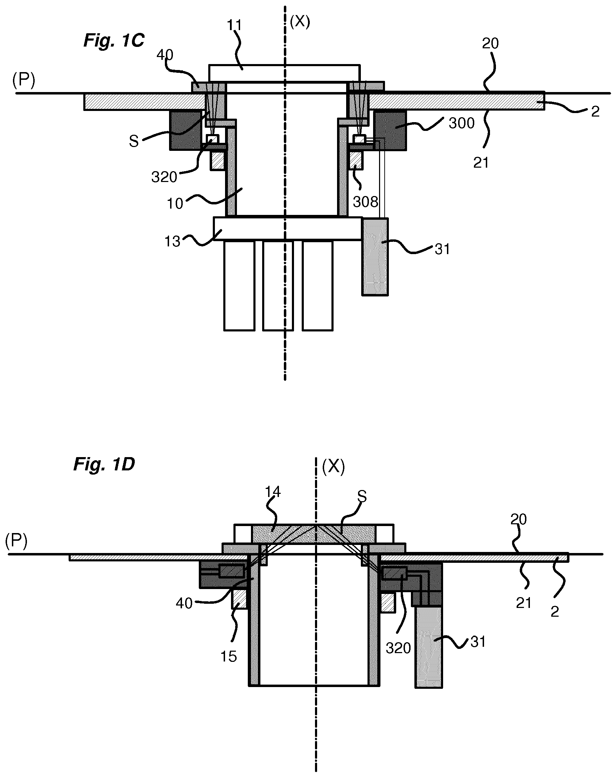

Sur la figure 1C, le dispositif coopère avec un organe de commande de type bouton poussoir. Le dispositif employé comporte ainsi un mode d'éclairage axial. L'élément 40 en matériau translucide ou transparent est formé au moins en partie du corps de l'organe. L'éclairage axial permet d'illuminer la collerette 100 de l'organe par le dessous.

Sur la figure 1D, le dispositif coopère avec un organe de visualisation ou avec un organe de commande de type bouton poussoir possédant un capuchon 14 transparent ou translucide. Le dispositif est choisi avec des diodes électroluminescentes émettant suivant une direction principale radiale. L'élément 40 est formé au moins en partie du corps de l'organe et le capuchon est également transparent ou translucide. Le signal lumineux généré par chaque diode électroluminescente traverse entièrement le corps 10 de l'organe et se diffuse à travers le capuchon 14, permettant ainsi d'obtenir un éclairage central, en complément d'une solution d'éclairage axiale présente dans l'organe ou en remplacement de celle-ci.

A partir des différentes configurations présentées ci-dessus, les figures 4A à 6C représentent le dispositif de signalisation visuelle de l'invention agencé sur différents types d'organe de commande et/ou de visualisation.

Sur les figures 4A à 4C, le dispositif est associé à un organe de commande de type bouton d'arrêt d'urgence. Il est maintenu contre la face interne 21 de la paroi 2 par les moyens de fixation du bouton. L'éclairage est radial et se diffuse par le corps 10 du bouton, sur toute sa hauteur, comme sur la figure 1B décrite ci-dessus. Le corps 10 est par exemple formé d'un assemblage de métal et de plastique. Il s'agira par exemple d'un surmoulage de l'élément en matériau translucide ou transparent sur un corps métallique. Il pourrait également s'agit d'un corps métallique présentant certaines cavités ou logements comblés par un matériau plastique translucide ou transparent.

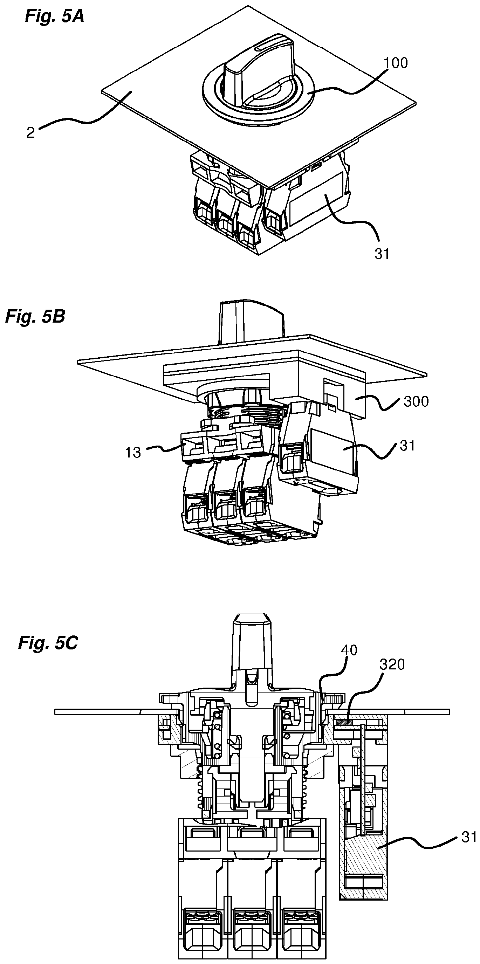

Sur les figures 5A à 5C, le dispositif est associé à un organe de commande de type bouton tournant. L'éclairage est également radial et est diffusé par le corps 10 du bouton. Il permet de venir éclairer la collerette 100 du bouton située contre la face externe 20 de la paroi.

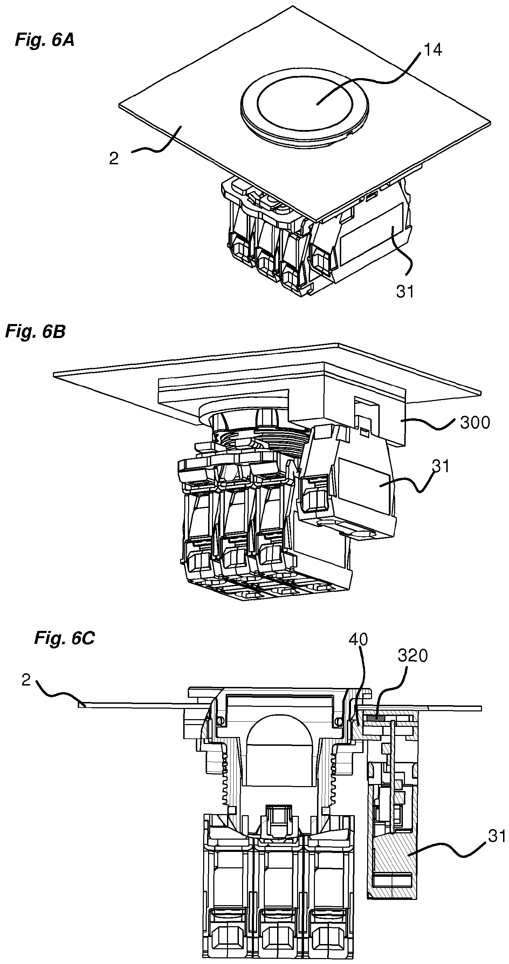

Sur les figures 6A à 6C, le dispositif est associé à un organe de visualisation doté d'un capuchon 14 transparent. Le corps 10 de l'organe est réalisé dans un matériau translucide ou transparent, permettant de laisser passer les signaux lumineux générés par les diodes électroluminescentes 320. Les signaux lumineux se propagent ainsi vers le centre de l'organe, et sont diffusés à travers le capuchon.

Il ressort de la description ci-dessus que le dispositif de signalisation visuelle de l'invention présente de nombreux avantages :
- Il permet d'obtenir un éclairage important, avec un encombrement limité au niveau de l'organe.
- Il est indépendant de l'organe, permettant ainsi d'être facilement remplacé et permettant au client de choisir à tout moment s'il souhaite ajouter un moyen de signalisation visuelle.
- Il est compatible avec différents types d'organe, la seule obligation étant la présence de l'élément en matériau translucide.
- Il permet d'assurer différents types d'éclairage, variables en couleurs, en position, selon la configuration du dispositif (diodes de couleurs différentes par exemple) et de celle des éléments 40 qui sont employés pour propager les signaux lumineux.
- Avec une solution d'éclairage radial, il permet un gain en encombrement en hauteur vers l'arrière de la paroi, sans nuire à la qualité de l'éclairage obtenu à l'avant de la paroi.

## Revendications

1. Dispositif de signalisation visuelle pour organe de commande et/ou de visualisation doté d'un corps (10) et destiné à être monté à travers une ouverture réalisée dans une paroi (2), dispositif comportant :
- Un élément support (30) comprenant une plateforme (300) présentant une ouverture (301) destinée à être traversée par le corps dudit organe de commande et/ou de visualisation et une première face destinée à être en vis-à-vis d'une face de la paroi,
- Un ensemble de signalisation visuelle (32) fixé sur la première face de ladite plateforme (300) et comprenant au moins une diode électroluminescente (320) destinée à produire un signal lumineux (S),
- Un bloc de connexion électrique (31) destiné à alimenter ledit ensemble de signalisation visuelle,
- **Caractérisé en ce que** ladite plateforme comporte au moins un passage radial (302) à travers lequel ladite au moins une diode électroluminescente (320) émet ledit signal lumineux (S).

2. Dispositif selon la revendication 1, **caractérisé en ce que** ladite plateforme comporte un logement réalisé en périphérie de son ouverture et dans lequel est logé ledit ensemble de signalisation visuelle.

3. Dispositif selon la revendication 1, **caractérisé en ce que** l'ensemble de signalisation visuelle comporte une carte électronique (321) sur laquelle est soudée ladite au moins une diode électroluminescente (320).

4. Dispositif selon la revendication 2 ou 3, **caractérisé en ce que** ladite au moins une diode électroluminescente (320) est orientée de manière à ce que son signal lumineux (S) présente une direction principale située dans un plan transversal par rapport à l'axe de l'ouverture.

5. Dispositif selon l'une des revendications 1 à 4, **caractérisé en ce que** l'ouverture (301) présente un contour circulaire.

6. Dispositif selon l'une des revendications 1 à 5, **caractérisé en ce que** la plateforme (300) comporte des moyens de fixation (303) agencés pour coopérer avec des moyens de fixation correspondants du bloc de connexion électrique (31).

7. Dispositif selon l'une des revendications 1 à 6, **caractérisé en ce qu'**il comporte une bague de serrage (308) solidaire de ladite plateforme (300).

8. Ensemble de commande et/ou de visualisation, comportant :
- Un organe de commande et/ou de visualisation comprenant un corps (10) défini suivant un axe, une tête de commande et/ou de visualisation monté sur ledit corps, l'organe de commande et/ou de visualisation comportant une collerette (100) agencée pour prendre appui contre une première face d'une paroi (2), dite face externe (20), définissant un plan d'appui (P),
- Ledit ensemble étant **caractérisé en ce qu'**il comporte :
- Un dispositif de signalisation visuelle conforme à celui défini dans l'une des revendications précédentes dont l'élément support coopère avec ledit corps de l'organe de commande et/ou de visualisation,
- Un élément (40) en matériau translucide ou transparent agencé pour recevoir ledit signal lumineux émis par l'ensemble de signalisation visuelle dudit dispositif de signalisation visuelle et pour propager ledit signal lumineux,
- Ledit élément (40) en matériau translucide ou transparent comportant une première zone agencée en vis-à-vis du passage radial à travers lequel ladite au moins une diode électroluminescente (320) émet ledit signal lumineux (S), pour recevoir ledit signal lumineux au-dessous dudit plan d'appui et une deuxième zone prolongeant la première zone jusqu'au plan d'appui ou au-dessus du plan d'appui.

9. Ensemble selon la revendication 8, **caractérisé en ce que** l'élément (40) en matériau translucide ou transparent est formée d'une pièce surmoulée sur le corps dudit organe de commande et/ou de visualisation.

10. Ensemble selon la revendication 8, **caractérisé en ce que** l'élément (40) en matériau translucide ou transparent est formée au moins en partie du corps dudit organe de commande et/ou de visualisation.

11. Ensemble selon l'une des revendications 8 à 10, **caractérisé en ce qu'**il comporte une bague de serrage (15) agencée pour maintenir le dispositif de signalisation visuelle en appui contre une deuxième face de la paroi, dite face interne (21), opposée à ladite face externe (20).

## Patentansprüche

1. Vorrichtung zur visuellen Signalisierung für ein Befehls- oder Meldeorgan, das mit einem Körper (10) ausgestattet ist und dazu bestimmt ist, durch eine in einer Wand (2) ausgeführte Öffnung hindurch montiert zu werden, wobei die Vorrichtung umfasst:
- ein Halteelement (30), umfassend eine Plattform (300), die eine Öffnung (301) aufweist, die dazu bestimmt ist, vom Körper des Befehls- und/oder Meldeorgans durchdrungen zu werden, und eine erste Seite, die dazu bestimmt ist, gegenüber einer Seite der Wand zu sein,
- eine Anordnung zur visuellen Signalisierung (32), die auf der ersten Seite der Plattform (300) befestigt ist und mindestens eine Leuchtdiode (320) umfasst, die dazu bestimmt ist, ein Lichtsignal (S) zu erzeugen,
- einen elektrischen Anschlussblock (31), der zu bestimmt ist, die Anordnung zur visuellen Signalisierung zu versorgen,
- **dadurch gekennzeichnet, dass** die Plattform mindestens einen radialen Durchlass (302) beinhaltet, durch den hindurch die mindestens eine Leuchtdiode (320) das Lichtsignal (S) aussendet.

2. Vorrichtung nach Anspruch 1, **dadurch gekennzeichnet, dass** die Plattform eine Aufnahme beinhaltet, die am Umfang ihrer Öffnung ausgeführt ist und in der die Anordnung zur visuellen Signalisierung aufgenommen ist.

3. Vorrichtung nach Anspruch 1, **dadurch gekennzeichnet, dass** die Anordnung zur visuellen Signalisierung eine Leiterplatte (321) beinhaltet, auf weiche die mindestens eine Leuchtdiode (320) geschweißt ist.

4. Vorrichtung nach Anspruch 2 oder 3, **dadurch gekennzeichnet, dass** die mindestens eine Leuchtdiode (320) derart ausgerichtet ist, dass ihr Lichtsignal (S) eine Hauptrichtung aufweist, die in einer quer zur Achse der Öffnung verlaufenden Ebene gelegen ist.

5. Vorrichtung nach einem der Ansprüche 1 bis 4, **dadurch gekennzeichnet, dass** die Öffnung (301) eine kreisförmige Kontur aufweist.

6. Vorrichtung nach einem der Ansprüche 1 bis 5, **dadurch gekennzeichnet, dass** die Plattform (300) Befestigungsmittel (303) umfasst, die dazu eingerichtet sind, mit entsprechenden Befestigungsmitteln des elektrischen Anschlussblocks (31) zusammenzuwirken.

7. Vorrichtung nach einem der Ansprüche 1 bis 6, **dadurch gekennzeichnet, dass** sie einen Klemmring (308) beinhaltet, der mit der Plattform (300) fest verbunden ist.

8. Befehls- und/oder Meldeanordnung, beinhaltend:
- ein Befehls- und/oder Meldeorgan, umfassend einen entlang einer Achse definierten Körper (10), einen an dem Körper montierten Befehls- und/oder Meldekopf, wobei das Befehls- und Meldeorgan einen Kragen (100) beinhaltet, der dazu eingerichtet ist, an einer ersten Seite einer Wand (2), Außenseite (20) genannt, anzuliegen, die eine Auflageebene (P) definiert,
- wobei die Anordnung **dadurch gekennzeichnet ist, dass** sie beinhaltet:
- eine Vorrichtung zur visuellen Signalisierung nach einem der vorhergehenden Ansprüche, deren Halteelement mit dem Körper des Befehls- und/oder Meldeorgans zusammenwirkt,
- ein Element (40) aus transluzentem oder transparentem Material, das dazu eingerichtet ist, das von der Anordnung zur visuellen Signalisierung der Vorrichtung zur visuellen Signalisierung ausgesendete Lichtsignal zu empfangen und das Lichtsignal zu verbreiten,
- wobei das Element (40) aus transluzentem oder transparentem Material einen ersten Bereich beinhaltet, der gegenüber dem radialen Durchlass eingerichtet ist, durch den hindurch die mindestens eine Leuchtdiode (320) das Lichtsignal (S) aussendet, um das Lichtsignal unter der Auflageebene zu empfangen, und einen zweiten Bereich, der den ersten Bereich bis zur Auflageebene oder oberhalb der Auflageebene verlängert.

9. Anordnung nach Anspruch 8, **dadurch gekennzeichnet, dass** das Element (40) aus transluzentem oder transparentem Material aus einem an den Körper des Befehls- und/oder Meldeorgans angeformten Teil gebildet ist.

10. Anordnung nach Anspruch 8, **dadurch gekennzeichnet, dass** das Element (40) aus transluzentem oder transparentem Material zumindest teilweise aus dem Körper des Befehls- und/oder Meldeorgans gebildet ist.

11. Anordnung nach einem der Ansprüche 8 bis 10, **dadurch gekennzeichnet, dass** sie einen Klemmring (15) beinhaltet, der dazu eingerichtet ist, die Vorrichtung zur visuellen Signalisierung an einer zweiten Seite der Wand anliegend, Innenseite (21) genannt, die zur Außenseite (20) entgegengesetzt ist, zu halten.

## Claims

1. Visual signalling device for a control and/or display unit provided with a body (10) and intended to be mounted through an opening formed in a wall (2), the device including:
- A support element (30) comprising a platform (300) having an opening (301) intended to be passed through by the body of said control and/or display unit and a first face intended to be facing a face of the wall,
- A visual signalling assembly (32) fastened on the first face of said platform (300) and comprising at least one light-emitting diode (320) intended to produce a luminous signal (S),
- An electrical connection block (31) intended to supply power to said visual signalling assembly,
- **Characterized in that** said platform includes at least one radial passage (302) through which said at least one light-emitting diode (320) emits said luminous signal (S).

2. Device according to Claim 1, **characterized in that** said platform includes a recess formed at the periphery of its opening and in which said visual signalling assembly is housed.

3. Device according to Claim 1, **characterized in that** the visual signalling assembly includes an electronic board (321) to which said at least one light-emitting diode (320) is soldered.

4. Device according to Claim 2 or 3, **characterized in that** said at least one light-emitting diode (320) is oriented in such a way that its luminous signal (S) has a main direction situated in a plane that is transverse with respect to the axis of the opening.

5. Device according to one of Claims 1 to 4, **characterized in that** the opening (301) has a circular outline.

6. Device according to one of Claims 1 to 5, **characterized in that** the platform (300) includes fastening means (303) designed to interact with corresponding fastening means of the electrical connection block (31).

7. Device according to one of Claims 1 to 6, **characterized in that** it includes a clamping ring (308) integral with said platform (300).

8. Control and/or display assembly, including:
- A control and/or display unit comprising a body (10) defined along an axis, a control and/or display head mounted on said body, the control and/or display unit including a bezel (100) designed to bear against a first face of a wall (2), termed external face (20), defining a bearing plane (P),
- Said assembly being **characterized in that** it includes:
- A visual signalling device according to the one defined in any one of the preceding claims, the support element of which interacts with said body of the control and/or display unit,
- An element (40) made of translucent or transparent material and designed to receive said luminous signal emitted by the visual signalling assembly of said visual signalling device and to propagate said luminous signal,
- Said element (40) made of translucent or transparent material including a first zone arranged facing the radial passage through which said at least one light-emitting diode (320) emits said luminous signal (S), for receiving said luminous signal below said bearing plane, and a second zone extending the first zone as far as the bearing plane or above the bearing plane.

9. Assembly according to Claim 8, **characterized in that** the element (40) made of translucent or transparent material is formed of a component moulded over the body of said control and/or display unit.

10. Assembly according to Claim 8, **characterized in that** the element (40) made of translucent or transparent material is formed at least partly by the body of said control and/or display unit.

11. Assembly according to one of Claims 8 to 10, **characterized in that** it includes a clamping ring (15) designed to hold the visual signalling device so that it bears against a second face of the wall, termed internal face (21), opposite said external face (20).
